# EUROPÄISCHE PATENTSCHRIFT

(11) **EP 1 758 165 B1**
(45) Veröffentlichungstag und Bekanntmachung des Hinweises auf die Patenterteilung: **27.04.2016**
(21) Anmeldenummer: 06017499.2
(22) Anmeldetag: 23.08.2006
(51) Int. Cl.: H01L 23/057, H01L 23/04, H01L 25/11

(54) **LEISTUNGSHALBLEITERMODUL MIT BEFESTIGUNGSEINRICHTUNG ZUR MONTAGE AUF EINEM KÜHLKÖRPER**
POWER SEMICONDUCTOR MODULE WITH MEANS FOR MOUNTING ON A HEATSINK
MODULE SEMI-CONDUCTEUR DE PUISSANCE À MOYENS DE FIXATION CONTRE UN DISSIPATEUR

(30) Priorität: 24.08.2005 DE 102005039947
(43) Veröffentlichungstag der Anmeldung: 28.02.2007
(73) Patentinhaber: SEMIKRON Elektronik GmbH & Co. KG, 90431 Nürnberg (DE)
(72) Erfinder: Ebersberger, Frank, 90518 Hilpoltstein (DE); Steger, Jürgen, 91355 Hilpoltstein (DE)

(56) Entgegenhaltungen:
- DE-A1- 3 940 933
- DE-A1- 10 316 356
- US-A- 5 107 074

## Beschreibung

Die Erfindung beschreibt ein Leistungshalbleitermodul zur Montage auf einem Kühlkörper, wobei das Leistungshalbleitermodul ein rechteckförmiges Grundraster aufweist. Das Leistungshalbleitermodul weist weiterhin ein Gehäuse, Lastanschlusselemente, sowie zwei an den Ecken angeordnete Befestigungseinrichtungen, vorzugsweise für eine Schraubverbindung auf. Moderne Ausgestaltungen von Leistungshalbleitermodulen mit hoher Leistung bezogen auf ihre Baugröße, die Ausgangspunkt dieser Erfindung sind, sind beispielhaft aus den Druckschriften DE 10 2004 025 609 A1 oder der DE 103 16 356 A1 bekannt.

Die DE 10 2004 025 609 A1 offenbart ein Leistungshalbleitermodul, zur Montage auf einem Kühlkörper, mit einem Gehäuse und mit Verbindungselementen für Last- und Hilfsanschlüsse. Die Lastanschlusselemente sind hierbei ausgebildet als Metallformkörper mit einer Ausnehmung für eine Schraubverbindung. Die Hilfsanschlüsse sind ausgebildet als Federkontaktelemente zur Druckkontaktierung mit einer oberhalb des Leistungshalbleitermoduls angeordneten Leiterplatte. Diese Leiterplatte bildet vorzugsweise die gesamte externe Zuleitung, sowohl der Last- als auch der Hilfsanschlüsse aus.

Eine derartige Ausgestaltung ist besonders geeignet für Leistungshalbleitermodule mit einer darin angeordneten Mehrzahl von Halbbrückenschaltungen, beispielsweise einer Dreiphasen- Brückenschaltung. Hierzu ist es vorteilhaft die beiden Gleichspannungsanschlüsse auf einer schmalen Seite und die Wechselspannungsanschlüsse auf einer breiten Seite anzuordnen. Besonders vorteilhaft an dieser Ausgestaltung eines Leistungshalbleitermoduls ist, dass dieses äußerst kompakt ausgebildet ist und hierzu die Befestigungseinrichtungen in den äußersten Ecken des Gehäuses angeordnet sind.

Aus der DE 103 16 356 A1 ist ein modular aufgebautes Leistungshalbleitermodul bekannt, welches durch Aneinanderreihung einer Mehrzahl von Teilmodulen aufgebaut ist. Hierbei werden die Teilmodule zu einem Leistungshalbleitermodule zusammengefügt oder direkt benachbart aneinander gereiht und mit einem gemeinsamen Deckel verbunden. Vorteilhaft hierbei ist, dass die Teilmodule äußerst kompakt, direkt benachbart zueinander, angeordnet sind. Nachteilig ist allerdings, dass durch den gemeinsamen Deckel der Austausch einzelner Teilmodule nicht einfach möglich ist.

Die US 5,107,074 beschreibt ein Leistungshalbleitermodul mit rechteckförmigem Grundraster und mit zwei an ersten diagonal gegenüberliegenden Ecken angeordneten Befestigungseinrichtungen und zwei an zweiten diagonal gegenüberliegenden Ecken angeordneten Aussparungen, wobei jeweils eine Befestigungseinrichtung in eine zugeordnete Aussparung eines direkt benachbart angeordneten Leistungshalbleitermoduls hineinragen kann.

Der vorliegenden Erfindung liegt die Aufgabe zu Grunde ein kompaktes Leistungshalbleitermodul vorzustellen, welches eine Platz sparende direkt benachbarte und reversible Anordnung mehrer gleichartiger Leistungshalbleitermodule in einfacher Weise erlaubt.

Diese Aufgabe wird gelöst durch eine Anordnung nach dem Anspruch 1, spezielle Ausgestaltungen finden sich in den Unteransprüchen. Der Grundgedanke der Erfindung geht aus von einem Leistungshalbleitermodul mit rechteckförmigem Grundraster zur Montage auf einem Kühlkörper. Das Leistungshalbleitermodul weist mindestens ein Gehäuse und Lastanschlusselemente auf, die an einer oder an zwei gegenüberliebenden ersten Seiten des Leistungshalbleitermoduls angeordnet sind.

Ebenso weist das Leistungshalbleitermodul zwei im Bereich der ersten diagonal gegenüberliegenden Ecken angeordnete Befestigungseinrichtungen auf. Vorzugsweise sind dies Einrichtungen zur Anordnung einer Schraubverbindung zu einem Kühlkörper. Die Befestigungseinrichtungen sind ausgestaltet als Teilformkörper des Leistungshalbleitermoduls und überragen dessen Seitenflächen teilweise in Richtung der Flächennormalen dieser Seitenflächen an den beiden nicht mit Anschlusselementen versehenen gegenüberliegenden zweiten Seiten

Weiterhin weist das Leistungshalbleitermodul zwei im Bereich der zweiten diagonal gegenüberliegenden Ecken angeordneten Aussparungen auf, wobei diese Aussparungen an den zweiten Seiten derart ausgebildet sind, dass jeweils eine Befestigungseinrichtung eines weiteren an einer zweiten Seite direkt benachbart angeordneten Leistungshalbleitermoduls in die zugeordnete Aussparung hineinragen kann.

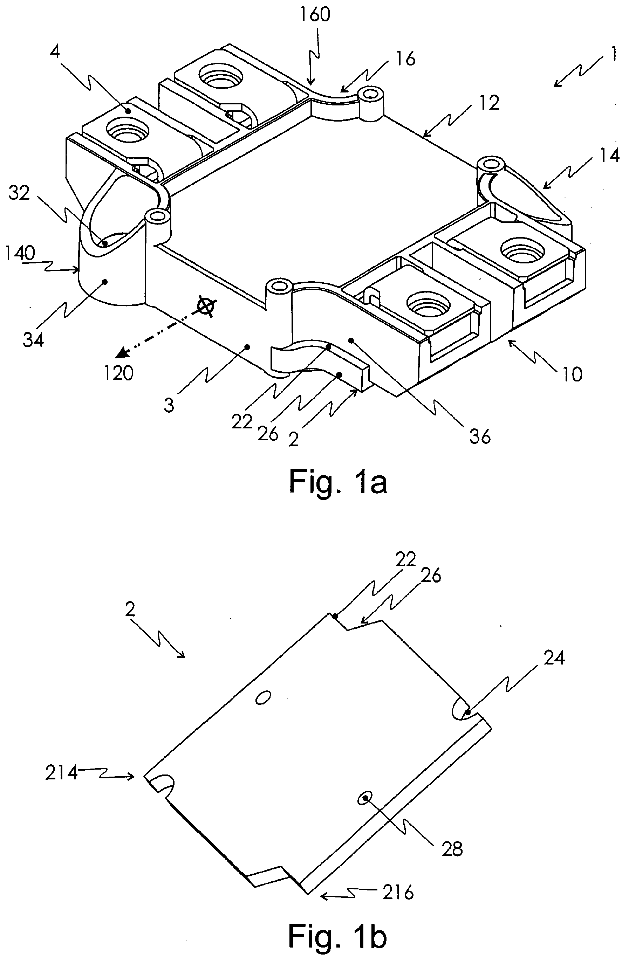

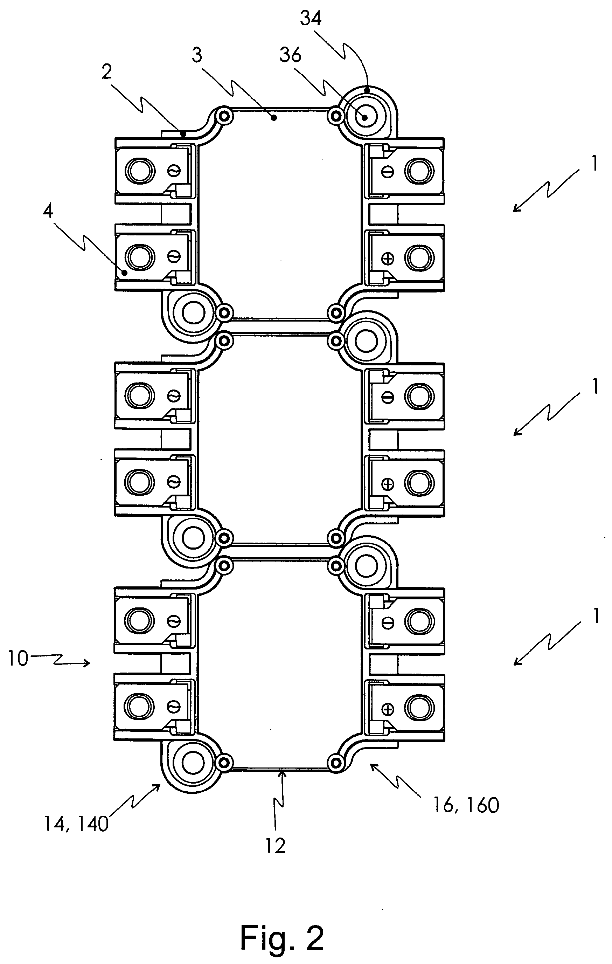

Die Erfindung wird anhand von Ausführungsbeispielen in Verbindung mit den Fig. 1 und 2 näher erläutert.

Fig. 1 zeigt ein erfindungsgemäßes Leistungshalbleitermodul.

Fig. 2 zeigt eine Aneinanderreihung einer Mehrzahl von erfindungsgemäßen Leistungshalbleitermodulen.

Fig. 1 zeigt eine Ausgestaltung eines erfindungsgemäß weitergebildeten Leistungshalbleitermoduls (1), wobei Fig. 1 a das Leistungshalbleitermodul (1) in dreidimensionaler Draufsicht zeigt, während Fi. 1 b die zugehörige Grundplatte (2) zeigt.

Das Leistungshalbleitermodul (1) gemäß Fig. 1 a weist eine Grundplatte (2) sowie ein Kunststoffgehäuse (3), welches darin angeordnete Leistungshalbleiterbauelemente umschließt, auf. Zur externen elektrischen Verbindung weist das Leistungshalbleitermodul (1) Elemente für Last- und nicht dargestellte Hilfsanschlüsse auf. Die Lastanschlusselemente (4) sind als Metallformkörper mit jeweils einer Ausnehmung für Schraubanschlüsse ausgebildet und an einer oder wie hier dargestellt zwei einander gegenüberliegenden ersten Seiten (10) des Leistungshalbleitermoduls (1) angeordnet sind.

Gemäß dem Stand der Technik weist das Gehäuse (3) Ausnehmungen (36) zur Befestigung einer Leiterplatte auf. Diese Leiterplatte dient beispielhaft der Ansteuerung der Leistungshalbleiterbauelement und zur Kontaktierung von modulinternen Sensoren.

Erfindungsgemäß weist das Gehäuse (3) zwei an ersten diagonal gegenüberliegenden Ecken (14) angeordneten Befestigungseinrichtungen (140) auf, die einen Teilkörper des Leistungshalbleitermoduls bilden. Hierzu weist das elektrisch isolierend ausgebildete Kunststoffgehäuse (3) Fortsätze (34) auf, die an den beiden nicht mit Anschlusselementen (4) versehenen gegenüberliegenden zweiten Seiten (12) das Leistungshalbleitermodul (1) diese jeweilige Seite (12) teilweise, im Bereich der zugeordneten Ecke (14) in Richtung der zugeordneten Flächennormalen (120) überragen.

Die Fortsätze (34) des Gehäuses (3) weisen ihrerseits runde Ausnehmungen (32)zur Durchführung einer Schraubverbindung mit einem nicht dargestellten Kühlkörper auf. Die Grundplatte (2) ihrerseits weist im Bereiche der Ecken (14) des Leistungshalbleitermoduls (1) keine Fortsetzungen auf und überragt somit auch nicht ihre entsprechende Seite. In den zugeordneten Ecken (214) der Grundplatte (2) sind mit den Ausnehmungen (32) der Fortsetzung (30) des Gehäuses (3) fluchtende Ausnehmungen (24) angeordnet. Diese sind als Kreissegmente ausgebildet, wobei das fehlende Kreissegment durch einen Teil der Fortsetzung (34) des Gehäuses (3) ausgebildet ist.

Das Gehäuse (3), wie auch die Grundplatte (2) des Leistungshalbleitermoduls (1) weisen zwei im Bereich der zweiten diagonal gegenüberliegenden Ecken (16) angeordneten Aussparungen (160) auf. Diese Aussparungen (160) an den zweiten Seiten (12) sind derart ausgebildet, dass jeweils eine Befestigungseinrichtung (140) mit der Fortsetzung (34) des Gehäuses (3) eines weiteren an einer zweiten Seite (12) direkt benachbart angeordneten Leistungshalbleitermoduls (1) in die zugeordnete Aussparung (160) hineinragen kann.

Da bei er erfindungsgemäßen Ausgestaltung des Leistungshalbleitermoduls (1) dieses nur an zwei ersten Ecken (14) auf einem Kühlkörper befestigt werden kann ist es besonders bevorzugt, wenn die Grundplatte (2) diagonal gebogen ist. Hierbei weist die Grundplatte eine diagonale, zylindrisch konvexe, Ausgestaltung derart auf, dass die den ersten Ecken (14) des Leistungshalbleitermoduls (1) zugeordneten Ecken (214) der Grundplatte (2) in Richtung des Gehäuses (3) gebogen sind. Diese Biegung der Grundplatte (2)weist in den Ecken (214) eine Abweichung von einer planen Grundplatte von weniger als zwei von hundert der maximalen Kantenlänge der Grundplatte (2) auf.

Es kann weiterhin bevorzugt sein, dass die Grundplatte (2) des Leistungshalbleitermoduls (1) an ihren Ecken (216) Aussparungen (26) aufweist, die weniger stark als die Aussparungen (36) des Gehäuses gegenüber der Seitenlinie zurückgenommen sind. Hierdurch bildet die Grundplatte (2) eine Andruckkante (22) aus. Diese Andruckkante (22) kann, ohne dass dies bildlich dargestellt ist, von Teilen der Fortsetzung (34) eines weiteren an einer zweiten Seite (12) direkt benachbart angeordneten Leistungshalbleitermoduls (1) und in die zugeordnete Aussparung (160) hineinragenden Fortsetzung (34) zumindest teilweise überdeckt werden. Somit wirkt dieser Teil der Fortsetzung (34) eines zweiten Leistungshalbleitermoduls auf die Ecke (16) des ersten Leistungshalbleitermoduls (1) und drückt diese bei einer Schraubbefestigung des zweiten Leistungshalbleitermoduls mit auf den Kühlkörper.

Fig. 2 zeigt eine Aneinanderreihung einer Mehrzahl von erfindungsgemäßen Leistungshalbleitermodulen (1). Dargestellte sind hier drei Leistungshalbleitermodule, wobei jedes eine Reihenschaltung von zwei Dioden mit einer Mittelanzapfung aufweist. Die gesamte damit realisierbare Schaltungstopologie ist somit eine dreiphasige Eingangsbrückenschaltung. Auf der linken Seite sind die drei Eingangsphasen der Wechselspannung mit je zwei Lastanschlüssen pro Leistungshalbleitermodul angeordnet, während auf der rechten Seite die Lastanschlüsse (4) der Gleichstromausgänge, die noch schaltungsgerecht verbunden werden müssen, angeordnet sind.

Die Darstellung zeigt wie die Leistungshalbleitermodule (1) mit ihren zweiten Seite (12) direkt benachbart zueinander angeordnet sind. Hierbei ragen die Befestigungseinrichtungen (140) eines Leistungshalbleitermoduls (1) in die zugeordnete Aussparung (160) des benachbarten Leistungshalbleitermoduls.

## Patentansprüche

1. Leistungshalbleitermodul (1), zur Montage auf einem Kühlkörper, mit rechteckförmigem Grundraster, mit einem Gehäuse (3), mit Lastanschlusselementen (4), mit zwei an ersten diagonal gegenüberliegenden Ecken (14) angeordneten Befestigungseinrichtungen (140) und zwei an zweiten diagonal gegenüberliegenden Ecken (16) angeordneten Aussparungen (160), wobei
die Lastanschlusselemente (4) an einer oder zwei einander gegenüberliegenden ersten Seiten (10) des Leistungshalbleitermoduls (1) angeordnet sind, wobei die Befestigungseinrichtungen (140) ausgebildet sind als Teilformkörper des Leistungshalbleitermoduls (1) und an den beiden nicht mit Anschlusselementen (4) versehenen gegenüberliegenden zweiten Seiten (12) das Leistungshalbleitermodul (1) die jeweilige Seite (12) teilweise in Richtung der Flächennormalen (120) dieser Seitenfläche überragen und wobei
die Aussparungen (160) an den zweiten Seiten (12) derart ausgebildet sind, dass jeweils eine Befestigungseinrichtung (140) eines weiteren an einer zweiten Seite (12) direkt benachbart angeordneten baugleichen Leistungshalbleitermoduls (1) in die zugeordnete Aussparung (160) hineinragen kann,
wobei das Gehäuse (3) den Teilformkörper der Befestigungseinrichtung (140) bildende Fortsetzungen (34) aufweist und diese ihrerseits erste Ausnehmungen (32) zur
Durchführung einer Schraubverbindung des Leistungshalbleitermoduls (1) mit einem Kühlkörper aufweisen,
wobei das Leistungshalbleitermodul eine Grundplatte (2) aufweist, die ebenso an den Ecken (216) Aussparungen (26) aufweist, sowie an den Ecken (214) zweite mit den ersten Ausnehmungen (32) fluchtende Ausnehmungen (24) aufweist zur Durchführung einer Schraubverbindung des Leistungshalbleitermoduls (1) mit einem Kühlkörper und
wobei die Aussparung (160) ausgebildet wird durch Aussparungen (36) des Gehäuses (3) sowie durch Aussparungen (26) der Grundplatte (2).

2. Leistungshalbleitermodul (1) nach Anspruch 1,
wobei die Aussparung (36) des Gehäuses größer ausgebildet ist als diejenige Aussparung (26) der Grundplatte (2) und somit eine Andruckkante (22) ausgebildet ist.

3. Leistungshalbleitermodul (1) nach Anspruch 1,
wobei Grundplatte (2) diagonal derart gebogen ist, dass die den ersten Ecken (14) des Leistungshalbleitermoduls (1) zugeordneten Ecken (214) der Grundplatte (2) in Richtung des Gehäuses (3) gebogen sind.

## Claims

1. Power semiconductor module (1) for mounting on a heat sink, having a rectangular basic grid, having a housing (3), having load connection elements (4), having two fastening devices (140) which are arranged at first diagonally opposite corners (14) and two cutouts (160) which are arranged at second diagonally opposite corners (16), wherein the load connection elements (4) are arranged on one or two mutually opposite first sides (10) of the power semiconductor module (1), wherein the fastening devices (140) are in the form of partial shaped bodies of the power semiconductor module (1) and, on the two opposite second sides (12) which are not provided with connection elements (4), the power semiconductor module (1) projects partially beyond the respective side (12) in the direction of the surface normal (120) of this side face, and wherein the cutouts (160) are formed on the second sides (12) in such a way that in each case one fastening device (140) of a further structurally identical power semiconductor module (1) which is arranged directly adjacent to a second side (12) can project into the associated cutout (160), wherein the housing (3) has projections (34) which form the partial shaped body of the fastening device (140) and which, for their part, have first recesses (32) for screw-connecting the power semiconductor module (1) to a heat sink, wherein the power semiconductor module has a base plate (2) which likewise has cutouts (26) at the corners (216), and has second recesses (24) which are aligned with the first recesses (32) at the corners (214) for screw-connecting the power semiconductor module (1) to a heat sink, and wherein the cutout (160) is formed by cutouts (36) in the housing (3) and by cutouts (26) in the base plate (2).

2. Power semiconductor module (1) according to Claim 1, wherein the cutout (36) in the housing is larger than the cutout (26) in the base plate (2) and therefore a contact-pressure edge (22) is formed.

3. Power semiconductor module (1) according to Claim 1, wherein the base plate (2) is diagonally bent in such a way that the corners (214) of the base plate (2), which corners are associated with the first corners (14) of the power semiconductor module (1), are bent in the direction of the housing (3).

## Revendications

1. Module semi-conducteur de puissance (1) destiné à être monté sur un corps de refroidissement et présentant
un bâti de base de forme rectangulaire, un boîtier (3), des éléments (4) de raccordement de charge, deux dispositifs de fixation (140) disposés sur des premiers coins diagonalement opposés (14) et deux découpes (160) disposées sur deux coins diagonalement opposés (16),
les éléments (4) de raccordement de charge étant disposés sur un ou deux premiers côtés mutuellement opposés (10) du module semi-conducteur de puissance (1),
les dispositifs de fixation (140) étant configurés comme corps moulés formant partie du module semi-conducteur de puissance (1) et sur les deux côtés opposés (12) non dotés d'éléments de raccordement (4), le module semi-conducteur de puissance (1) débordant partiellement en direction de la normale (120) à la surface de chaque côté (12), au-delà de ce côté,
les découpes (160) prévues sur les deuxièmes côtés (12) étant configurées de telle sorte qu'un dispositif de fixation (140) d'un autre module semi-conducteur de puissance (1) de même structure disposé directement au voisinage d'un deuxième côté (12) puisse pénétrer dans la découpe (160) associée,
le boîtier (3) présentant des prolongements (34) qui forment le corps moulé partiel du dispositif de fixation (140) et ces derniers présentant pour leur part des premières découpes (32) permettant le passage d'une liaison filetée entre le module semi-conducteur de puissance (1) et un corps de refroidissement,
le module semi-conducteur de puissance présentant une plaque de base (2) qui présente également des découpes (26) sur les coins (216), et sur les coins (214) des deuxièmes découpes (24) alignées sur les premières découpes (32) en vue du passage d'une liaison filetée entre le module semi-conducteur de puissance (1) et un corps de refroidissement, la découpe (160) étant formée par des découpes (36) du boîtier (3) ainsi que par des découpes (26) de la plaque de base (2).

2. Module semi-conducteur de puissance (1) selon la revendication 1, dans lequel la découpe (36) du boîtier est plus grande que la découpe (26) de la plaque de base (2), pour ainsi former un bord de poussée (22).

3. Module semi-conducteur de puissance (1) selon la revendication 1, dans lequel la plaque de base (2) est cintrée en diagonale de telle sorte que les coins (214) de la plaque de base (2) associés aux premiers coins (14) du module semi-conducteur de puissance (1) soient cintrés en direction du boîtier (3).
